(19) Europäisches Patentamt
European Patent Office
Office européen des brevets

(11) **EP 4 672 244 A1**

(12) **EUROPEAN PATENT APPLICATION**

(43) Date of publication:
**31.12.2025 Bulletin 2026/01**

(21) Application number: **25170948.1**

(22) Date of filing: **16.04.2025**

(51) International Patent Classification (IPC):
**G11C 7/10** (2006.01)     **H04B 5/26** (2024.01)

(52) Cooperative Patent Classification (CPC):
**G11C 7/10; H04B 5/26; H04B 5/263**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **28.06.2024 US 202418757544**

(71) Applicant: **Intel Corporation**
**Santa Clara, CA 95054 (US)**

(72) Inventors:
• **DORRANCE, Richard**
  **Beaverton, 97006 (US)**
• **FOUST, Kenneth**
  **Beaverton, 97007 (US)**

• **LIU, Renzhi**
  **Portland, 97229 (US)**
• **MOREIN, Stephen**
  **San Jose, 95148 (US)**
• **PELLERANO, Stefano**
  **Beaverton, 97007 (US)**
• **YAMADA, Shuhei**
  **Vancouver, 98684 (US)**
• **YANG, Tae Young**
  **Portland, 97229 (US)**
• **ZHOU, Zhen**
  **Chandler, 85248 (US)**

(74) Representative: **Viering, Jentschura & Partner mbB**
**Patent- und Rechtsanwälte**
**Am Brauhaus 8**
**01099 Dresden (DE)**

(54) **DOUBLE COIL INDUCTIVE SCHEME AND MODULATION FOR Z-AXIS MEMORY LINKS**

(57) Disclosed herein are devices, systems, and methods for driving inductive links in a memory such as a z-axis memory. The memory includes a first memory cell connected via a first inductive link comprising a first pair of double coils and a second memory cell connected via a second inductive link comprising a second pair of double coils. The first inductive link is arranged adjacent to the second inductive link. A driver circuit is configured to simultaneously drive the first and second pair of double coils with a drive current to read or write the first and second memory cells using the first and second inductive links.

FIG. 1

EP 4 672 244 A1

## Description

## Technical Field

The disclosure relates generally to memory layouts with inductive links, and in particular, to z-axis memories and ways of reducing crosstalk between inductive links of nearby memory cells.

## Background

As computing becomes more complex, such as with artificial intelligence (AI) computing, memory requirements may also become more demanding. AI-centric applications, for example, often demand more memory access and hence require even more memory density around the computing elements such as the central processing units (CPUs), graphics processing units (GPUs), or accelerated strategic computing interface (ASCI) enabled accelerators. As a result, memories often have a higher cell density and may be stacked on top of one another. For example, z-axis memory (ZAM) may have an increased memory density, where High Bandwidth Memory (HBM) is rotated 90 degrees and stacked to form a z-axis Memory stack (ZAM) and multiple ZAMs may be stacked around the host dies. Communication between the host dies and the ZAMs is realized through inductive coupling links. Due to the proximity of the inductive links, the magnetic interference may impact the signal to interference and noise ratio (SINR) significantly, especially when adjacent links are driven simultaneously to read/write to memory cells. To ensure the data and the clock recovery, ZAMs may requires more complicated equalizer design and error coding, and, consequently, may lead to more power consumption, higher latency, and larger die area.

## Brief Description of the Drawings

In the drawings, like reference characters generally refer to the same parts throughout the different views. The drawings are not necessarily to scale, emphasis instead generally being placed upon illustrating the exemplary principles of the disclosure. In the following description, various exemplary aspects of the disclosure are described with reference to the following drawings, in which:

FIG. 1 shows an example stack-up of a z-axis memory (ZAM) with inductive links;
FIG. 2 shows an example of adjacent inductive coupling links, each fed by a single coil;
FIG. 3 illustrates an example of adjacent inductive coupling links, each fed by a double coil pair;
FIGs. 4A and 4B show examples of a double coil pair that may be used in an inductive coupling link;
FIGs. 5A and 5B illustrate examples of driving a double coil pair in a common current mode or differential current mode, respectively;
FIG. 6 shows a graph that plots the current of the drive signal over time in a simulation of driving a double coil pair and a single coil;
FIGs. 7-9 plot various results of a simulation of driving a double coil pair in a differential mode as compared to driving a single coil;
FIGs. 10-12 plot various results of a simulation of driving a double coil pair in a common current mode as compared to driving a single coil;
FIG. 13 depicts a multidimensional array of double coil pairs of driven coils for multiple rows of inductive links and their associated driving schemes;
FIG. 14 illustrates an example stack-up of high bandwidth memory stacked on top of a base die;
FIG. 15A shows an example of feeding coils, from a driver in the base die, in a differential current mode;
FIG. 15B shows an example of feeding coils, from a driver in the base die, in a common current mode;
FIGs. 16-17 illustrate examples of a double coil pair that is fed using a single feed port;
FIG. 18 depicts an example of communicating a baseband data signal without modulation over an inductive link;
FIG. 19 depicts an example of communicating a baseband data signal with modulation over an inductive link; and
FIG. 20 shows an example of a circuit that may provide for modulation and encoding of baseband data when communicating over an inductive link.

## Description

The following detailed description refers to the accompanying drawings that show, by way of illustration, exemplary details and features.

The word "exemplary" is used herein to mean "serving as an example, instance, or illustration." Any aspect or design described herein as "exemplary" is not necessarily to be construed as preferred or advantageous over other aspects or designs.

Throughout the drawings, it should be noted that reference numbers may be similar to one another and thus used to depict the same or similar elements, features, and structures, unless otherwise noted.

The phrase "at least one" and "one or more" may be understood to include a numerical quantity greater than or equal to one (*e.g.,* one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (*e.g.,* "plural [elements]", "multiple [elements]") referring to a quantity of elements expressly refers to more than one of the said elements. For instance, the phrase "a plurality" may be understood to include a numerical quantity greater than or equal to two (*e.g.,* two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, *e.g.,* provided as a file, a portion of a file, a set of files, a signal or stream, a portion of a signal or stream, a set of signals or streams, and the like. Further, the term "data" may also be used to mean a reference to information, *e.g.,* in the form of a pointer. The term "data", however, is not limited to the aforementioned examples and may take various forms and represent any information as understood in the art.

The terms "processor" or "controller" as, for example, used herein may be understood as any kind of technological entity (e.g., hardware, software, and/or a combination of both) that allows handling of data. The data may be handled according to one or more specific functions executed by the processor or controller. Further, a processor or controller as used herein may be understood as any kind of circuit, *e.g.,* any kind of analog or digital circuit. A processor or a controller may thus be or include an analog circuit, digital circuit, mixed-signal circuit, software, firmware, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium (*e.g.,* a non-transitory computer-readable medium) in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D XPoint™, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (*e.g.,* the transmission of radio signals) and logical transmission (*e.g.,* the transmission of digital data over a logical software-level connection). For example, a processor or controller may transmit or receive data over a software-level connection with another processor or controller in the form of radio signals, where the physical transmission and reception is handled by radio-layer components such as radio frequency (RF) transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both "direct" calculations via a mathematical expression/formula/relationship and 'indirect' calculations via lookup or hash tables and other array indexing or searching operations. References to the TX/RX "chain" or "path" refer to the series of processing steps to convert, modulate, amplify, filter, etc. the data signal to be transmitted (along the TX path) from the antenna or to the series of processing steps to convert, modulate, amplify, filter, etc. the desired signal (along the RX path) that is to be recovered from the received signal at the antenna. References to a "desired" signal refer to the predefined signal that is to be received by the communication device at the prescribed time.

As noted above, in high density memories such as in a ZAM, communication between the host dies and the ZAMs may be realized through inductive coupling links. Due to the proximity of the inductive links in a high density memory, when adjacent links are activated simultaneously, they may interfere with each other, where the magnetic interference may significantly impact the signal to interference and noise ratio (SINR). In some cases, the SINR may be so high that the memory avoids activating adjacent links. The drawback is that this may reduce memory access speed by half.

To reduce the interference from one inductive coupling link on nearby (adjacent) links, without the need to avoid activating the nearby (adjacent) links, disclosed herein is a double coil pair (also called a differential coil pair) that may be used in the inductive coupling link in a memory such as a ZAM. By taking advantage of the double coil pair and driving them (e.g., via a driver circuit (e.g., a signal generator, current generator, voltage generator, etc.)) in versatile ways, the interference between simultaneously driven adjacent links may be reduced, allowing adjacent links of a memory to be operated (read/writing adjacent memory cells) simultaneously.

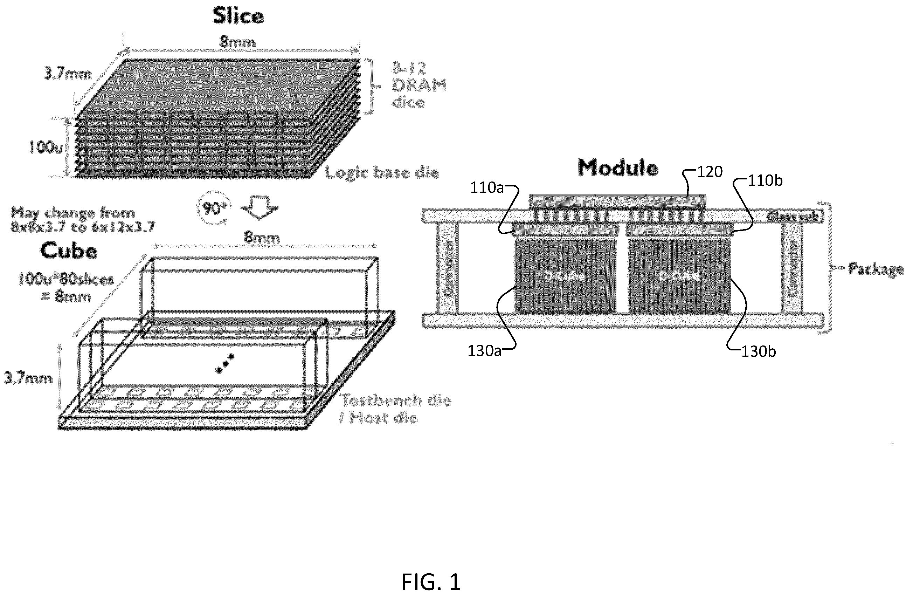

FIG. 1 shows an example stack-up of a z-axis memory (ZAM). Unlike traditional memories that are typically two-dimensional, with data stored on a flat plane, a ZAM may add a third dimension, enabling the stacking of memory cells vertically. The idea behind a ZAM is to increase the memory density and overall storage capacity without expanding the footprint of the memory chip. A host die may communicate with the ZAMs using inductive coupling links with each layer in the ZAM. As shown in FIG. 1, a memory module may include multiple host dies (e.g., host die 110a and host die 110b) operated by the same memory processor 120, each host die of which may have its own "D-Cube" or -z-axis stack of memory layers (e.g., D-cube 130a and D-cube 130b), where the ends of each layers may be fed by inductive coupling links between the host die and the memory layer.

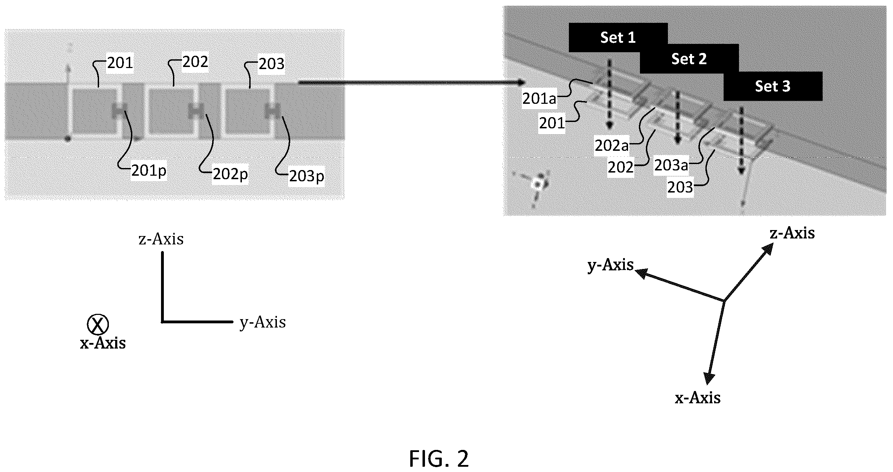

In traditional coupling links, each inductive coupling link includes a set of single coil inductors. An example of three adjacent sets of single coil inductive coupling link is shown on the left of FIG. 2, which shows a cross section along the z-axis and y-axis of a ZAM, where the horizontal axis is the y-axis, the vertical axis is the z-axis, and the x-axis is into the page. In this configuration, each of the single coils 201, 202, and 203 feed a respective row of memory cells (into the page; not shown on the left side of FIG. 2) within a given layer of the stack. Coil 201 is fed by a single port 201p, coil 202 is fed by a single port 202p, and coil 203 is fed by a single port 203p. The row for single coil 201 is adjacent to the row for coil 202. And the row for coil 202 is adjacent to the rows for coil 201 and for coil 203. The right side of FIG. 2 shows a different perspective so that multiple layers of the stack may be seen, where the stacked inductive coupling links form stacked sets. In particular, Set 1 is formed from coil 201 stacked with coil 201a, Set 2 is formed from coil 202 stacked with coil 202a, and Set 3 is formed from coil 203 stacked with coil 203a. If the one of the single coil inductive coupling links in the set is driven, it may interfere with the other single coil inductive coupling link in the set. Typically, a single coil is driven in balanced mode.

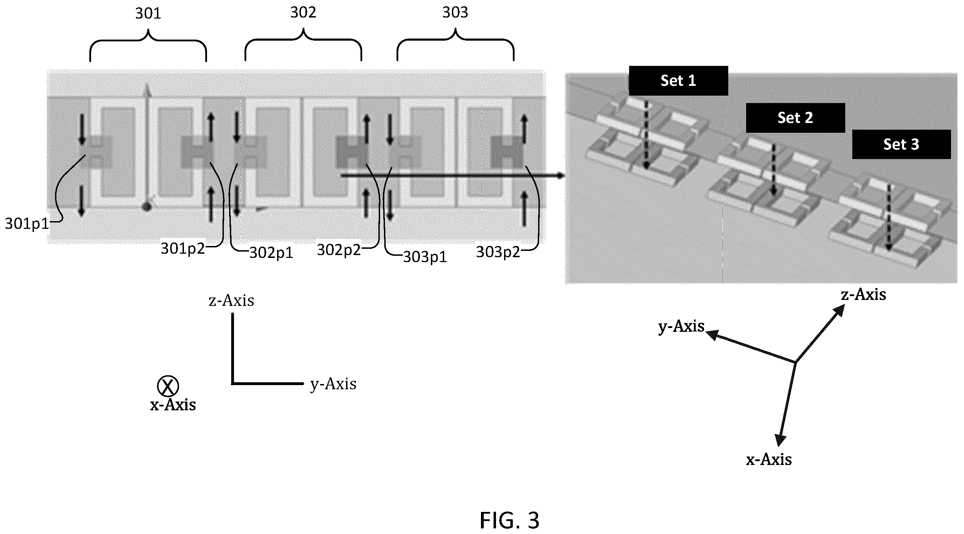

In contrast to the single coil inductive coupling link shown in FIG. 2, FIG. 3 shows the disclosed double coil pair inductive coupling links, where each single coil inductive coupling link of FIG. 2 has been replaced with a double coil pair inductive coupling link. As can be seen on the left side of FIG. 3, the double coil pair 301 is formed from two coils, one coil of which is fed by a differential port 301p1 and the other coil of which is fed by a differential port 301p2. Similarly, double coil pair 302 is formed from two coils, one coil of which is fed by a differential port 302p1 and the other coil of which is fed by a differential port 302p2. Similarly, double coil pair 303 is formed from two coils, one coil of which is fed by a differential port 303p1 and the other coil of which is fed by a differential port 303p2. The right side of FIG. 3 shows a similar perspective as the right side of FIG. 2, except that each single coil has been replaced with a double coil pair.

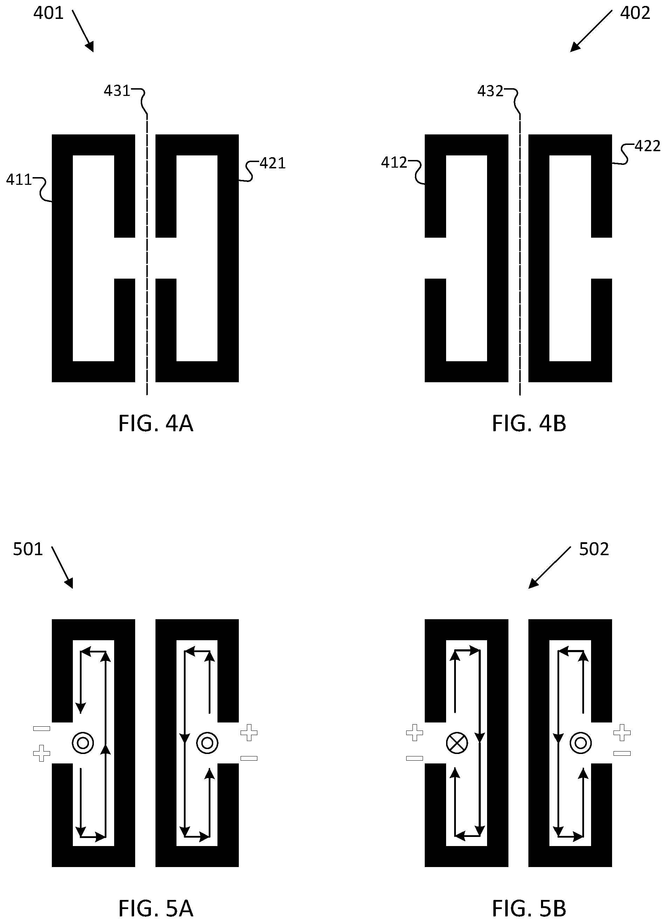

FIG. 4A and FIG. 4B show different examples of a double coil pair that may be used in an inductive coupling link. Double coil pair 401 has two C-shaped coils, 411 and 421, where the openings face each other along an interface 431 between to the coils. In FIG. 4B, double coil pair 402 has two C-shaped coils, 412 and 422, where the portions with the openings face away from each other and the closed portions of the C-shape are along the interface 432 between to the coils. The opening in each coil may be fed by a feed port for driving (e.g., via a driver circuit) the respective coil in the double coil pair. Thus, for double coil pair 401, the two C-shaped coils (411 and 421) have feed locations that are centrally located, while for double coil pair 402, the two C-shaped coils (412 and 422) have feed locations that are arranged on opposite sides. As should be understood, the C-shape and location of the feed port are merely exemplary, and any complementary (e.g., symmetric) shapes and may be used for the coil pair and the feed ports may be located anywhere along the coils.

This disclosed double coil pair (e.g., double coil pair 401 or 402) may be driven (e.g., via one or more driver circuits) in either in common current mode or differential current mode. Depending on the driving mode, a different magnetic field is generated in each coil, creating different magnetic configurations between the coils in the pair, which may have an impact on the link performance pertaining to the transmission strength and signal-to-interference and noise ratio (SINR) at a given communication distance. When the double coil pair is driven in a common current mode, as shown with double coil pair 501 in FIG. 5A, the magnetic field (H-Field) generated by the current flowing in each coil point to the same direction (e.g., following the right hand screw rule, as indicated by the double-circle, out of the page). By contrast, when the double coil pair is driven in a differential current mode, as shown with double coil pair 502 in FIG. 5B, the magnetic field (H-Field) generated by the current flowing in each coil point in opposite directions (e.g., following the right hand screw rule, the left coil of double coil pair 502 generates a magnetic field into the page as indicated by the circled-x, whereas the right coil of double coil pair 502 generates a magnetic field out of the page as indicated by the double circle).

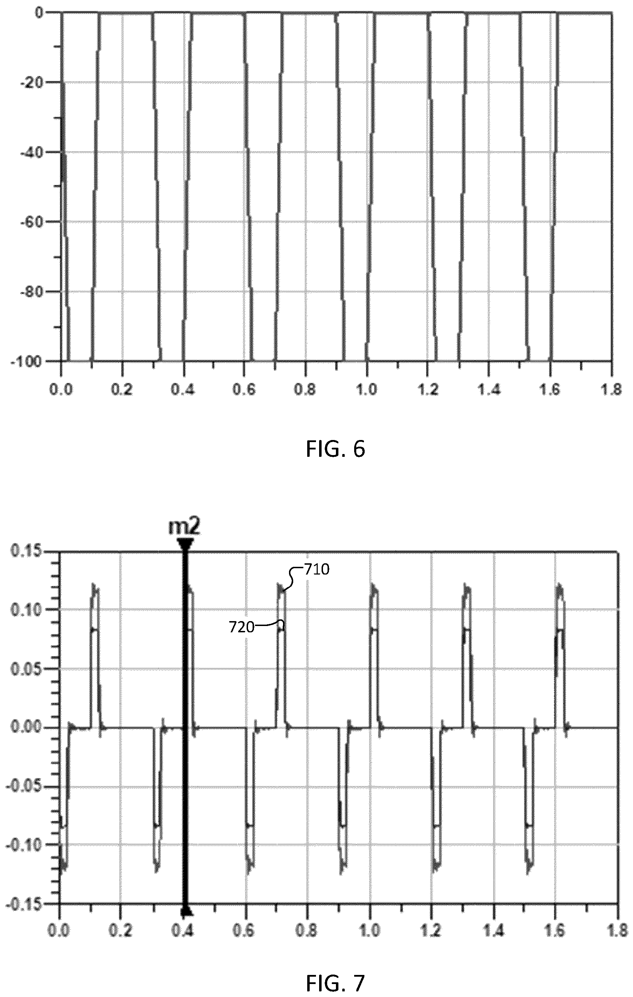

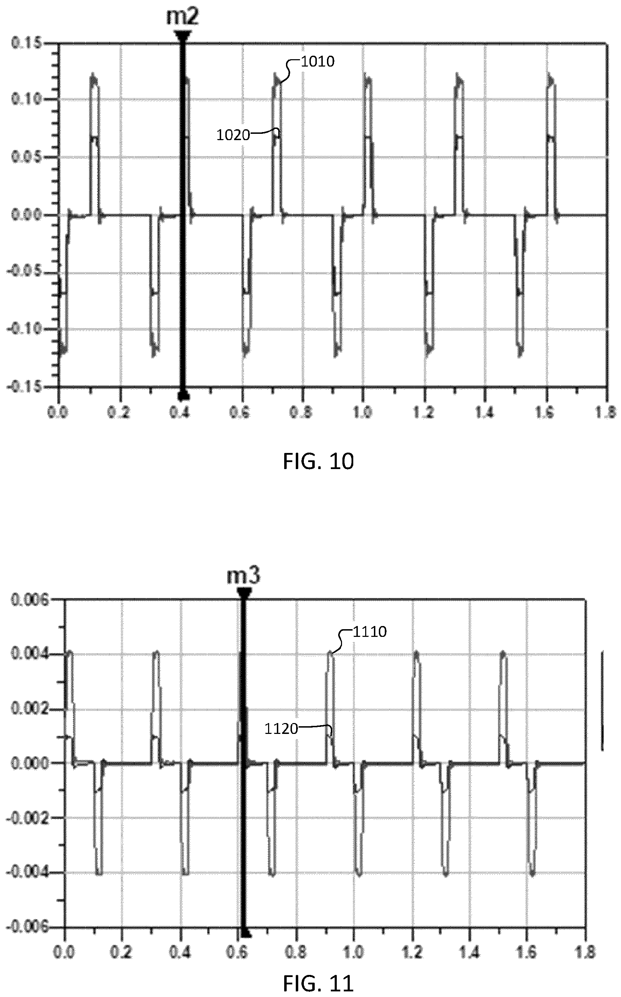

To compare the performance of a single coil inductive coupling link versus a double coil pair coupling link, a simulation was performed to evaluate the interference of adjacent links (e.g., on one victim by one aggressor). Referencing, for example, a high bandwidth memory (HBM) on a host die (e.g., as shown in FIG. 2 for single coil links and in FIG. 3 for double coil pair links), the aggressor may be the top coil in coil Set 3 (e.g., the stacked "Set 3" on the right side of FIG. 2 or the stacked "Set 3" on the right side of FIG. 3) on the HBM side while the victim may be the bottom coil in Set 3 on the host die side. For the double coil configuration, both current driving modes were simulated and compared to the single coil configuration. FIG. 6 shows a graph that plots the current of the driving signal (y-axis) over time (x-axis, in nanoseconds). FIGs. 7-9 plot results for the double coil driven in differential current mode while FIG. 10-12 plot results for the double coil driven in common current mode.

FIG. 7 is a graph that plots the direct voltage (y-axis) of the single coil and the double coil over time (x-axis, in nanoseconds). A peak voltage for the single coil curve is labeled at 710 while a peak voltage for the double-coil curve is labeled at 720. The line at M2 is at 404.6 picoseconds, where the single coil voltage peak is at 0.102 V while the double coil voltage peak is at 0.084 V.

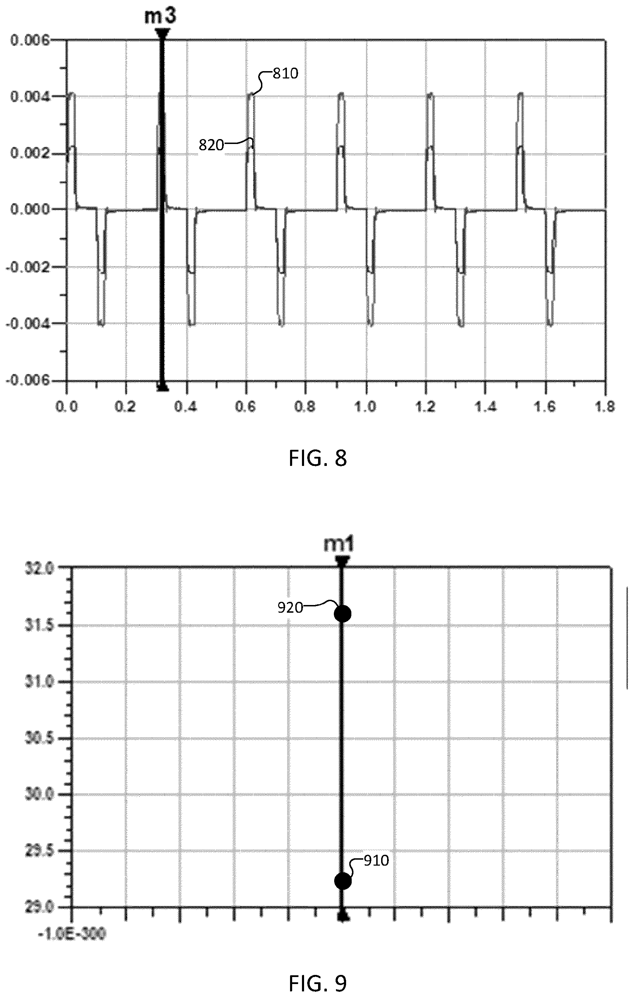

FIG. 8 is a graph that plots the crosstalk voltage (y-axis) of the single coil and the double coil over time (x-axis, in nanoseconds). A peak voltage for the single coil curve is labeled at 810 while a peak voltage for the double-coil curve is labeled at 820. The line at M3 is at 318.6 picoseconds, where the single coil crosstalk voltage peak is at 0.004 V while the double coil crosstalk voltage peak is at 0.002 V.

FIG. 9 is a graph that plots the SINR (y-axis) of the single coil and the double coil. SINR for the single coil curve is labeled at 910 and has a value of 29.240 while SINR for the double-coil curve is labeled at 920 and has a value of 31.611.

FIG. 10 is a graph that plots the direct voltage (y-axis) of the single coil and the double coil over time (x-axis, in nanoseconds). A peak voltage for the single coil curve is labeled at 1010 while a peak voltage for the double-coil curve is labeled at 1020. The line at M2 is at 404.6 picoseconds, where the single coil voltage peak is at 0.102 V while the double coil voltage peak is at 0.070 V.

FIG. 11 is a graph that plots the crosstalk voltage (y-axis) of the single coil and the double coil over time (x-axis, in nanoseconds). A peak voltage for the single coil curve is labeled at 1110 while a peak voltage for the double-coil curve is labeled at 1120. The line at M3 is at 620.6 picoseconds, where the single coil crosstalk voltage peak is at 0.004 V while the double coil crosstalk voltage peak is at 0.001 V.

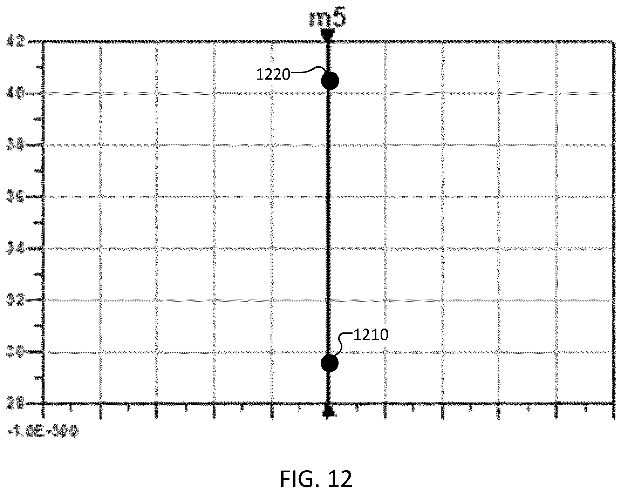

FIG. 12 is a graph that plots the SINR (y-axis) of the single coil and the double coil. SINR for the single coil curve is labeled at 1210 and has a value of 29.508 while SINR for the double-coil curve is labeled at 1220 and has a value of 40.696.

Comparing the single coil to the double coil pair, the double coil pair experiences a certain level of current cancellation between the two coils in the pair, depending on their current driven mode. Evaluating the double coil performance in the differential current mode compared to the common current mode, the common current mode induces less current cancellation, and hence offers a 17% more link strength, as may be seen by comparing FIG. 7 and FIG. 10.

Because the achievable SINR of a link may be a key performance indicator, the comparisons of the SINRs for the double coil compared to the single coil are plotted in FIGs. 9 and 12. The SINR is calculated using the

$$SINR = \frac{P}{I+N}$$

formula ，where $P$ is the power of the signal while $I$ is the power of the interference and $N$ is the power of the noise. Because the driving current is a time-variant signal, the parameters in the SINR equation above may be taken as the maximum value over a certain period time.

As shown in FIG. 12, the differential current mode offers 11.9 dB SINR margin gain as compared to the single coil configuration. As shown in FIG. 9, the common current mode offers a 2.4 dB SINR margin gain as compared to the single coil configuration. As should be understood, these are the results of a simplified simulation, and in real world conditions, one type of current driven mode might be more suitable than another depending on the driving distance or other factors.

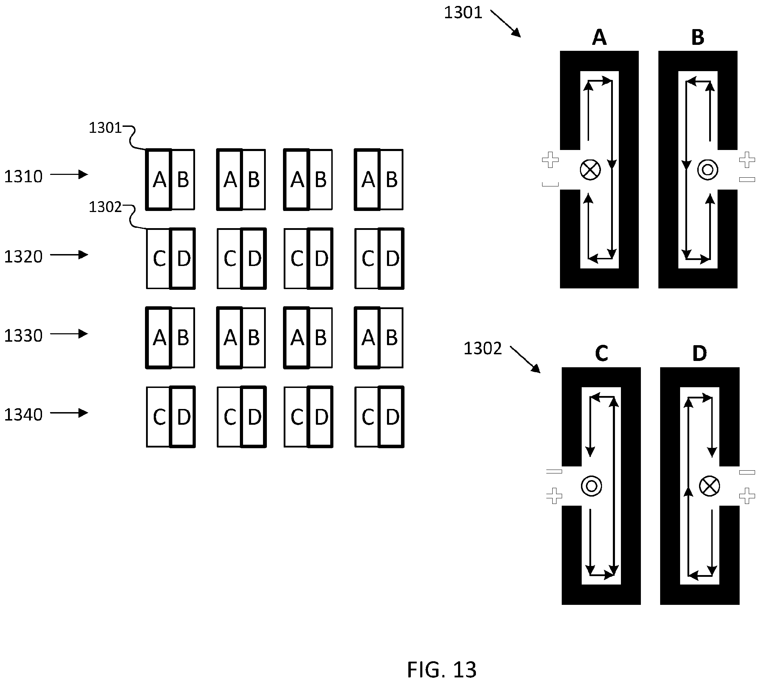

To extend the double coil pair approach from one dimensional memory array to a two dimensional memory array, the arrangement shown to the left of FIG. 13 may be used to take advantage of the driving mode flexibility offered by the double coil pair. In this alternate driving mode scheme, the H-Field polarities alters from one row to another so that the interferences from aggressors on their victims may have an opposite H-Field polarity and cancel out the interference. In the example on the left of FIG. 13, four rows are shown (row 1310, row 1320, row 1330, and row 1340), each with four links made of double coil pairs. Row 1310 and row 1330 use AB coil pairs while row 1320 and 1340 use CD coil pairs. An example AB coil pair is shown at the top right of FIG. 13 as 1301 while an example CD coil pair is shown at the bottom right of FIG. 13 as 1302. As can be seen, the H-field polarity of the A coil is into the page while the H-field polarity of the B coil is out of the page. As can also be seen, the H-field polarity of the C coil is out of the page, while the H-field polarity of the D coil is into the page. Thus, when stacked in alternating rows, as shown to the left in FIG. 13, the H-Field polarity of any given coil is the opposite to the H-field polarity of each of its adjacent coils.

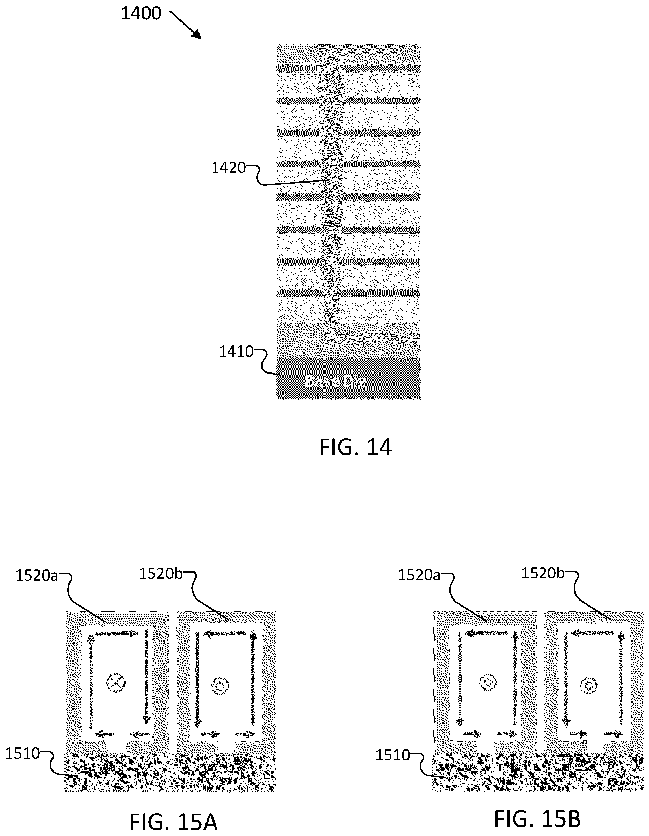

In a real-world implementation, the HBM stack may be stacked on top of a base die 1410, as shown, for example in FIG. 14, where the driving circuits may be fabricated in the base die 1410. Thus, it may be difficult to drive a coil 1420 with a feed port in the middle of the stack. Thus, the feed port and the opening (e.g., the opening in the C-shape) may face the base die. Examples of this are shown in FIGs. 15A and 15B, which show coil 1520a and coil 1520b of the double coil pair on a base die 1510, where the feed ports for the coils are on the base die 1510. FIG. 15A shows feeding the coils in a differential current mode, while FIG. 15B shows feeding the coils in a common current mode.

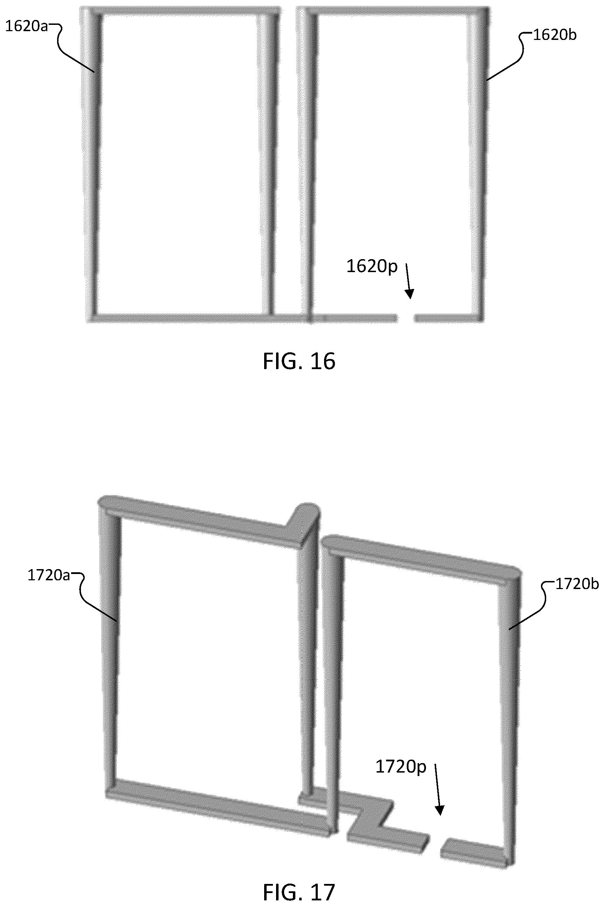

While the discussions and figures above of the double coil pair have been based on a separate feed port for each coil in the double coil pair, the double coil pair may be constructed such with a single feed port that drives both coils of the double coil pair. An example is shown in FIGs. 16 and 17. As shown in FIG. 16, a single feed port at 1620p may be used to drive the left coil 1620a as well as the right coil 1620b. A perspective drawing of the double coil pair of FIG. 16 is shown in FIG. 17, where the coils may be offset along an axis and be formed from a continuous figure-8 shape that forms the left coil 1720a and the right coil 1720b, both fed by a single feed port 1720p. An advantage of a single feed port is that the number of driving circuits may be reduced by half as compared to the case where each coil in the double coil pair is individually driven. While it may be difficult to have crossings in the middle of an HBM die stack, it may be simpler to form crossings by taking advantage of the presence of the top and bottom preservations and redistribution layers (RDLs), as shown in the perspective view of FIG. 17, where the top and bottom crossing structures (e.g., in the RDLs) may be seen. One of the crossing structures is placed on a top RDL layer, which may simply employ a 90° turn on the top RDL. Another crossing structure may be implemented on the bottom RDL layer, which may also take two turns as shown in FIG. 17, and, in this sense, may be asymmetric.

To improve the efficiency of an inductive link, the baseband data may be used to modulate a carrier at the resonance frequency of the inductive link. As one example, 20 GHz. In this manner, most of the data spectral energy may be upconverted to be around the center of the inductive link pass-band frequency, reducing signal filtering and improving overall link efficiency as compared to non-modulated signals. In an example implementation, the carrier signal may be generated by allowing the inductive link to self-oscillate so that the frequency of the carrier signal is located where the link's pass-band frequency is located, regardless of process, fabrication, and assembly variations. A capacitance may be added to tune adjacent inductive links so that they resonate at different carrier frequencies, thereby reducing the amount of crosstalk between adjacent links due to interference. In addition, a coding scheme (e.g., Manchester encoding) may also be added to the modulation so as to provide for clock recovery, so that a dedicated inductive link is not required to transmit the clock.

By using modulation, the inductive link may have a higher efficiency and reduce the overall power consumption of the inputs/outputs between the host die and memory die, potentially making the ZAM pluggable solution competitive with conventional hard-wired memory interfaces. By employing a low complexity circuit implementation for clock and data transmission/recovery, it may be easy to implement this scheme in more complex memories such as in a DRAM process. Because the modulation may provide improved isolation (e.g., due to selecting different carrier frequencies for adjacent or nearby links), it may be possible to pack more channels into the same area, increasing the overall throughput (e.g., bits/mm$^2$).

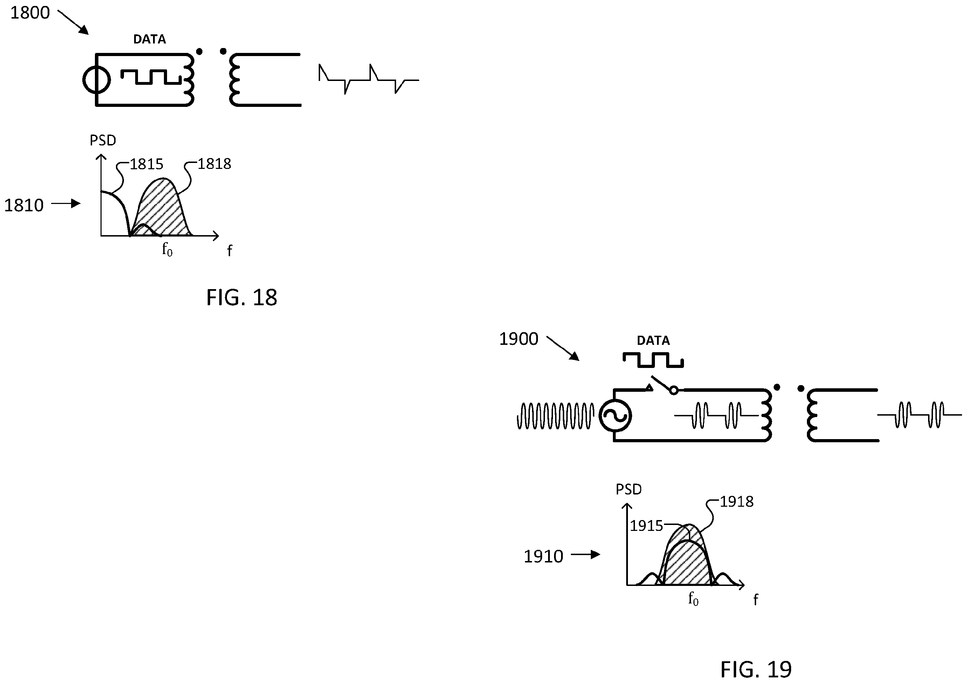

Modulating the inductive link means that instead of directly using the baseband data to apply current pulses to drive the transmit coil (which, in turn, creates voltage pulses at the receiver on the order of a few tens of millivolts), the link may be configured to resonate/oscillate at a self-resonance frequency. This resonance/oscillation may then be modulated (e.g., using on-off keying (OOK) or other types of modulation such as a multi-bit modulation like multilevel ASK) by the baseband data at the transmitter and demodulated at the receiver using a demodulator (e.g., a peak or envelope detector or other types of receivers). A benefit of modulation is that the baseband data may be upconverted to be around the pass-band frequency of the inductive link, thereby improving the efficiency of the link (e.g., compared to the case where the baseband data (e.g., centered around DC)) may be heavily filtered after passing though the inductive link and its pass-band response. An example of the baseband/DC case is shown in FIG. 18, where baseband data is transmitted through an inductive link as shown in a simplified circuit 1800. Graph 1810 depicts the baseband data 1815 and the passband filtering at the center frequency ($f_0$) of the link's pass-band response 1818. As can be seen, because the center frequency ($f_0$) of the link's pass-band response 1818 is above the baseband signal, a large portion of the baseband data 1815 may be filtered out. By contrast, FIG. 19 shows how modulation may improve the transmission efficiency, where the modulated baseband data 1915 better aligns with the center frequency ($f_0$) of the link's pass-band response 1918. As a result of the modulation and alignment to the center frequency of the link's pass-band response 1918, transmissions over the link may be more efficient.

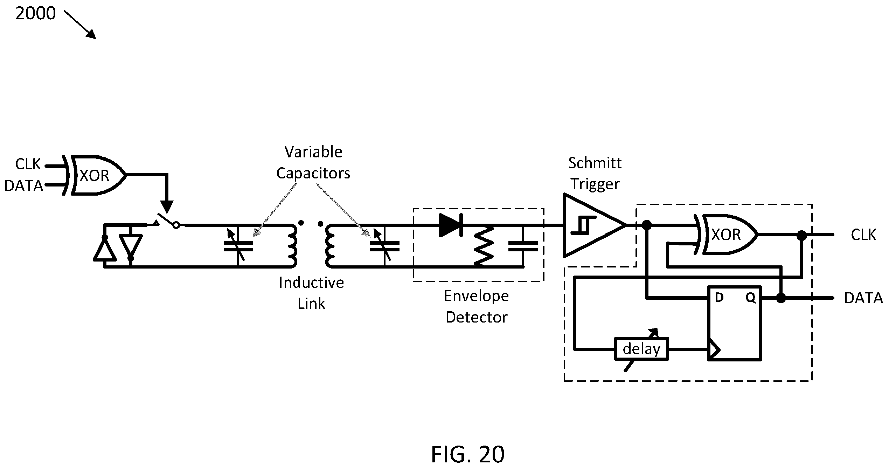

FIG. 20 shows an example of a circuit 2000 that may provide for modulation and recovery of baseband data over an inductive link. The carrier signal may be generated by allowing the inductive link to self-oscillate, which may be modulated by the baseband data (e.g., using OOK modulation or another modulation scheme). A variable capacitance may be added to the link to tune its center frequency so that, for example, adjacent inductive links may resonate at different center frequencies. Circuit 2000 is configured to apply on the transmitter side a Manchester encoding (e.g., an XOR of the baseband data with the clock signal) so as to allow for clock and data recovery at the receiver side (e.g., via a clock and data recovery circuit). On the receiver side, an envelope detector may be used to recover the encoded data signal, and the recovered data signal may be conditioned using a Schmitt Trigger before de-encoding to recover the baseband data and the clock. As should be understood, circuit 2000 is merely exemplary and other modulation schemes, receivers, and encoding/decoding schemes may be used.

In the following, various examples are provided that may include one or more features of the inductive links discussed above. It may be intended that aspects described in relation to the devices may apply also to the described method(s), and vice versa.

Example 1 is a memory including a first memory cell connected via a first inductive link including a first pair of double coils, a second memory cell connected via a second inductive link including a second pair of double coils, wherein the first inductive link is arranged adjacent to the second inductive link, and a driver circuit configured to simultaneously drive the first and second pair of double coils with a drive current to read or write the first and second memory cells using the first and second inductive links.

Example 2 is the memory of example 1, wherein the driver circuit is configured to simultaneously drive the first and second pair of double coils in a common current mode or a differential current mode.

Example 3 is the memory of example 2, wherein the common current mode is configured to generate a first magnetic field in a first coil of the first pair of double coils, in a first direction and to generate a second magnetic field in a second coil of the first pair of double coils in a second direction that is opposite to the first direction.

Example 4 is the memory of example 2, wherein the differential current mode is configured to generate a first magnetic field in a first coil of the first pair of double coils in a first direction and to generate a second magnetic field in a second coil of the first pair of double coils also in the first direction.

Example 5 is the memory of any one of examples 1 to 4, wherein each of the first and second pair of double coils include a first feed port that feeds a first coil of the double coils and a second feed port that feeds a second coil of the double coils.

Example 6 is the memory of example 5, wherein the first coil is adjacent the second coil in an interface region along an interface portion of each coil, wherein the feed ports are within the interface portion.

Example 7 is the memory of example 5, wherein the first coil is adjacent the second coil in an interface region along an interface portion of each coil, wherein the feed ports are outside of the interface portion.

Example 8 is the memory of any one of examples 1 to 7, wherein a first coil and a second coil of the first pair of double coils each include a C shape with an open face and a closed face.

Example 9 is the memory of example 8, wherein the open face of the first coil faces toward the open face of the second coil.

Example 10 is the memory of example 8, wherein the closed face of the first coil faces the closed face of the second coil.

Example 11 is the memory of any one of examples 1 to 10, wherein the memory includes a z-axis memory (ZAM), wherein the first memory cell and the second memory cell are stacked along a z-axis of the ZAM.

Example 12 is the memory of any one of examples 1 to 11, wherein the driver circuit is configured to apply pulses to the first pair of double coils and the second pair of double coils based directly on a baseband dataset.

Example 13 is the memory of any one of examples 1 to 12, wherein the driver circuit is configured to apply pulses to the to the first pair of double coils based on a modulation of a baseband dataset for the first memory cell at a resonance frequency.

Example 14 is the memory of example 13, the driver circuit is configured to apply pulses to the second pair of double coils based on a second modulation of a second baseband dataset for the second memory cell at a second resonance frequency.

Example 15 is the memory of any one of examples 13 to 14, wherein the modulation includes an on-off keying modulation or an amplitude shift key (ASK) modulation.

Example 16 is the memory of any one of examples 13 to 15, wherein the resonance frequency includes a self-resonance frequency as between a first coil and a second coil of the first pair of double coils.

Example 17 is the memory of any one of examples 13 to 16, wherein the driver circuit is configured to encode the modulation with an encoding.

Example 18 is the memory of example 17, wherein the encoding includes a Manchester encoding.

Example 19 is the memory of any one of examples 1 to 18, wherein the driver circuit further includes a modulation circuit, wherein the first inductive link or the second inductive link have a self-resonance frequency at the resonance frequency.

Example 20 is the memory of example 19, wherein the first inductive link or the second inductive link includes a variable capacitor, wherein the self-resonance frequency is based on a capacitance of a variable capacitor.

Example 21 is the memory of any one of examples 1 to 20, wherein the driver circuit further includes a demodulation circuit for recovering a baseband dataset from a modulation of the baseband dataset.

Example 22 is the memory of example 21, wherein the demodulation circuit includes an envelope detector.

Example 23 is the memory of any one of examples 1 to 22, wherein the memory includes a first row and a second row of memory cells, wherein the first and second memory cells are arranged within the first row, wherein the memory further includes a third memory cell including a third pair of double coils and a fourth memory cell including a fourth pair of double coils, wherein the third memory cell and fourth memory cell are arranged adjacent to each other within the second row, wherein the driver circuit is further configured to drive a first coil of the first pair of double coils to generate a first magnetic field in the first coil of the first pair of double coils in a first direction, drive a second coil of the first pair of double coils to generate a second magnetic field in the second coil in a second direction that is opposite to the first direction, drive a first coil of the of the third pair of double coils to generate a third magnetic field in the first coil of the third pair of double coils in the second direction, and drive a second coil of the third pair of double coils to generate a fourth magnetic field in the second coil of the third pair of double coils in the first direction.

Example 24 is the memory of example 23, wherein the driver circuit is further configured to drive the first coil of the second pair of double coils to generate a fifth magnetic field in the first coil of the second pair of double coils in the first direction, drive a second coil of the second pair of double coils to generate a sixth magnetic field in the second coil of the second pair of double coils in the second direction, drive a first coil of the fourth pair of double coils to generate a seventh magnetic field in the first coil of the fourth pair of double coils in the second direction, and drive a second coil of the fourth pair of double coils to generate an eighth magnetic field in the second coil of the fourth cell in the first direction.

Example 25 is the memory of any one of examples 1 to 24, wherein the driver circuit includes a first driver circuit and a second driver circuit, wherein the first driver circuit is configured to drive one coil of the double coils with the drive current, wherein the second driver circuit is configured to drive the other coil of the double coils with the drive current.

Example 26 is the memory of any one of examples 1 to 25, wherein the driver circuit includes a single driver circuit for driving both of the double coils with the drive current.

Example 27 is the memory of any one of examples 1 to 26, wherein the double coils include a single port connected to the driver circuit to drive both coils of the double coils with the drive current.

Example 28 is the memory of example 27, wherein the double coils are arranged as a figure eight differential inductor within a die stack of the memory.

Example 29 is the memory of example 28, wherein a first lobe of the figure eight includes the first coil of the double coil and a second lobe of the figure eight includes the second coil, wherein the first lobe is asymmetric with respect to the second lobe.

While the disclosure has been particularly shown and described with reference to specific aspects, it should be understood by those skilled in the art that various changes in form and detail may be made therein without departing from the spirit and scope of the disclosure as defined by the appended claims. The scope of the disclosure is thus indicated by the appended claims and all changes, which come within the meaning and range of equivalency of the claims, are therefore intended to be embraced.

## Claims

1. A memory comprising:

   a first memory cell connected via a first inductive link comprising a first pair of double coils;
   a second memory cell connected via a second inductive link comprising a second pair of double coils, wherein the first inductive link is arranged adjacent to the second inductive link; and
   a driver circuit configured to simultaneously drive the first and second pair of double coils with a drive current to read or write the first and second memory cells via the first and second inductive links.

2. The memory of claim 1, wherein the driver circuit is configured to simultaneously drive the first pair of double coils and the second pair of double coils in a common current mode or a differential current mode.

3. The memory of claim 2, wherein the common current mode is configured to generate a first magnetic field in a first coil of the first pair of double coils in a first direction and to generate a second magnetic field in a second coil of the first pair of double coils in a second direction that is opposite to the first direction.

4. The memory of any one of claims 2 or 3, wherein the differential current mode is configured to generate a first magnetic field in a first coil of the first pair of double coils in a first direction and to generate a second magnetic field in a second coil of the first pair of double coils also in the first direction.

5. The memory of any one of claims 1 to 4, wherein each of the first and second pair of double coils comprise a first feed port that feeds a first coil of the double coils and a second feed port that feeds a second coil of the double coils.

6. The memory of any one of claims 1 to 5, wherein a first coil of the first pair of double coils and a second coil of the first pair of double coils each comprise a C shape with an open face and a closed face.

7. The memory of any one of claims 1 to 6, wherein the memory comprises a z-axis memory (ZAM), wherein the first memory cell and the second memory cell are stacked along a z-axis of the ZAM.

8. The memory of any one of claims 1 to 7, wherein the driver circuit is configured to apply pulses to the first pair of double coils based directly on a baseband dataset.

9. The memory of any one of claims 1 to 8, wherein the driver circuit is configured to apply pulses to the first pair of double coils based on a modulation of a baseband dataset for the first memory cell at a resonance frequency.

10. The memory of claim 9, the driver circuit is configured to apply pulses to the second pair of double coils based on a second modulation of a second baseband dataset for the second memory cell at a second resonance frequency.

11. The memory of any one of claims 9 or 10, wherein the modulation comprises an on-off keying (OOK) modulation or an amplitude shift key (ASK) modulation.

12. The memory of any one of claims 9 to 11, wherein the resonance frequency comprises a self-resonance frequency as between a first coil and a second coil of the first pair of double coils.

13. The memory of any one of claims 9 to 12, wherein the driver circuit is configured to encode the modulation with a Manchester encoding.

14. The memory of any one of claims 1 to 13, wherein the driver circuit further comprises a modulation circuit, wherein the first or second inductive link has a self-resonance frequency at the resonance frequency; preferably wherein the first inductive link or the second inductive link includes a variable capacitor, wherein the self-resonance frequency is based on a capacitance of the variable capacitor.

15. The memory of any one of claims 1 to 14, wherein the memory comprises a first row and a second row of memory cells, wherein the first and second memory cells are arranged within the first row, wherein the memory further comprises a third memory cell comprising a third pair of double coils and a fourth memory cell comprising a fourth pair of double coils, wherein the third memory cell and fourth memory cell are arranged adjacent to each other within the second row, wherein the driver circuit is further configured to:

    drive a first coil of the first pair of double coils to generate a first magnetic field in the first coil of the first pair of double coils in a first direction; drive a second coil of the first pair of double coils to generate a second magnetic field in the second coil of the first pair of double coils in a second direction that is opposite to the first direction; drive a first coil of the third pair of double coils to generate a third magnetic field in the first coil of the third pair of double coils in the second direction; and drive a second coil of the third pair of double coils to generate a fourth magnetic field in the second coil of the third pair of double coils in the first direction; preferably wherein the driver circuit is further configured to:

    drive a first coil of the second pair of double coils to generate a fifth magnetic field in the first coil of the second pair of double coils in the first direction; drive a second coil of the second pair of double coils to generate a sixth magnetic field in the second coil of the second pair of double coils in the second direction; drive a first coil of the fourth pair of double coils to generate a seventh magnetic field in the first coil of the fourth pair of double coils in the second direction; and drive a second coil of the fourth pair of double coils to generate an eighth magnetic field in the second coil of the fourth pair of double coils in the first direction.

FIG. 1

FIG. 2

FIG. 3

401

431

411

421

FIG. 4A

402

432

412

422

FIG. 4B

501

FIG. 5A

502

FIG. 5B

FIG. 6

FIG. 7

FIG. 8

FIG. 9

FIG. 10

FIG. 11

FIG. 12

FIG. 13

FIG. 14

FIG. 15A

FIG. 15B

FIG. 16

FIG. 17

FIG. 18

FIG. 19

FIG. 20

Europäisches
Patentamt
European
Patent Office
Office européen
des brevets

# EUROPEAN SEARCH REPORT

**Application Number**

EP 25 17 0948

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SHIBA KOTA ET AL: "Crosstalk Analysis and Countermeasures of High-Density Multi-Hop Inductive Coupling Interface for 3D-Stacked Memory", 2020 IEEE ELECTRICAL DESIGN OF ADVANCED PACKAGING AND SYSTEMS (EDAPS), IEEE, 14 December 2020 (2020-12-14), pages 1-3, XP033876105, DOI: 10.1109/EDAPS50281.2020.9312890 [retrieved on 2021-01-04] * the whole document * | 1-15 | INV. G11C7/10 H04B5/26 |
| A | US 2015/004904 A1 (LISI GIANPAOLO [US] ET AL) 1 January 2015 (2015-01-01) * paragraph [0016] - paragraph [0018]; figure 3 * | 1-15 | |

**TECHNICAL FIELDS SEARCHED (IPC)**

G11C
H04B

The present search report has been drawn up for all claims

| Place of search | Date of completion of the search | Examiner |
|---|---|---|
| The Hague | 16 September 2025 | Knack, Steffen |

EPO FORM 1503 03.82 (P04C01)

## ANNEX TO THE EUROPEAN SEARCH REPORT
## ON EUROPEAN PATENT APPLICATION NO.

EP 25 17 0948

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2025

| Patent document cited in search report | Publication date | Patent family member(s) | Publication date |
|---|---|---|---|
| US 2015004904 A1 | 01-01-2015 | US 2015004904 A1 | 01-01-2015 |
| | | US 2015004907 A1 | 01-01-2015 |
| | | US 2016254846 A1 | 01-09-2016 |
| | | US 2017012677 A1 | 12-01-2017 |
| | | US 2018115346 A1 | 26-04-2018 |

EPO FORM P0459

For more details about this annex : see Official Journal of the European Patent Office, No. 12/82